# EUROPEAN PATENT SPECIFICATION

(11) **EP 1 559 225 B1**
(45) Date of publication and mention of the grant of the patent: **31.10.2007**
(21) Application number: 02761783.6
(22) Date of filing: 19.09.2002
(51) Int. Cl.: H04J 3/06, H04L 12/40, H04L 7/033, H04H 7/00, B60R 16/02

(54) **MECHANISM AND METHOD FOR AUDIO SYSTEM SYNCHRONIZATION**
VORRICHTUNG UND VERFAHREN FÜR DIE SYNCHRONISATION VON AUDIOSYSTEMEN
MECANISME ET PROCEDE DE SYNCHRONISATION DE SYSTEME D'ECOUTE

(43) Date of publication of application: 03.08.2005
(73) Proprietor: Honeywell, Inc., Morristown, NJ 07962-9806 (US)
(72) Inventor: GOLDBERG, Mark, L., Peoria, AZ 85381 (US); BECKER, Eric, Peoria, AZ 85381 (US)
(74) Representative: Haley, Stephen
(86) International application number: PCT/US2002/030041
(87) International publication number: WO 2004/028051

(56) References cited:
- US-A- 3 745 248
- US-A- 4 378 598
- US-A- 4 519 069
- US-A- 5 923 902

## Description

### BACKGROUND OF THE INVENTION

### TECHNICAL FIELD

This invention generally relates to electronic systems, and more specifically relates to distributed audio systems.

### BACKGROUND ART

Modem life is becoming more dependent upon electronic systems. Electronics devices have evolved into extremely sophisticated devices, and may be found in many different applications. As electronics become more integrated into daily life, their ability to communicate and work together becomes a greater and greater necessity.

The ability for electronic devices to work together is particularly problematic where the devices are remote from one another. In many applications, remote devices must be well integrated together to function properly. For example, in some audio systems, remote devices must be synchronized to properly function together. Without an effective means for synchronization of these audio devices, the separate audio devices cannot effectively function together.

Specifically, it is often desirable that remote audio devices by synchronized such that outputs and inputs at the remote audio devices occur together. This improves the sound quality by limiting interference between sounds generated by remote devices.

Unfortunately, in the past it has been difficult to provide the needed synchronization between remote audio devices. For example, in some cases the devices are remote enough that sharing a high speed clock signal between devices is impractical or otherwise undesirable.

Thus, what is needed is an improved method for synchronizing remote audio devices.

US-A-5923902 discloses a device having a plurality of remote audio devices each coupled to a bus with synchronisation associated therewith.

The present invention provides an apparatus and a corresponding method, the apparatus comprising:
a plurality of remote audio devices, each of the plurality of audio devices coupled to a bus and receiving a bus signal, each of the plurality of audio devices including:
   a microphone input, the microphone input adapted to sample sound for distribution on the bus;
   a speaker adapted to output sound distributed on the bus;
   a clock, the clock having a clock rate; and
   a synchronization means, the synchronization means adapted to receive the bus signal and compare bus signal to the clock, the synchronization means further adapted to adjust the clock rate of the clock to synchronize the sampling of sound with sampling of sound on other of the plurality of audio devices.

The preferred exemplary embodiment of the present invention will hereinafter be described in conjunction with the appended drawings, where like designations denote like elements, and:
FIG. 1 is a schematic view of a distributed audio system;
FIG. 2 is a schematic view of audio device with a synchronization mechanism;
FIG. 3 is a flow diagram of a method for synchronization;
FIG. 4 is a table illustrating a clock adjustment scheme; and
FIG. 5 is a table illustrating a scheme to determine when to make clock adjustments.

### DETAILED DESCRIPTION OF THE DRAWINGS

The present invention provides a synchronization mechanism and method for synchronizing remote audio devices that are coupled together with a bus. The synchronization mechanism compares a signal on the bus with a clock signal on the audio device and adjusts the clock in response to the comparison. This allows the synchronization mechanism to accurately synchronize remote audio devices without requiring high precision clocks or other complicated solutions.

The synchronization mechanism and method are particularly applicable to synchronizing remote audio devices in a distributed audio system that digitally sample and broadcast for communication purposes. In this application, the synchronization mechanism improves audio quality by synchronizing the sampling and outputting of each audio device on the bus. This improves audio quality by reducing the distortion that occurs as a result of varying sample times.

For example, the synchronization mechanism can be used in a distributed audio system for aircraft. In aircraft audio systems, several audio panels are located throughout the aircraft to facilitate communication between crew members and/or ground stations. In these applications, each audio panel typically includes a microphone input and a speaker output. Each audio panel is connected to a bus. Thus, audio information can be received at each microphone unit and put on the bus for distribution to other audio panels, where it is outputted by the speakers on the audio panels. This distributed audio system thus allows crew members at different locations throughout the plane to effectively communicate to each other.

In aircraft, the audio quality provided by the distributed audio system is of paramount importance. Without synchronization of the sampling and outputting times, the audio quality of the distributed audio system can be severely limited. The present invention provides a synchronization mechanism and method that can synchronize the operations of remote audio panels in an aircraft distributed audio system. The synchronization mechanism is used to synchronize the sampling and outputting that occurs at each audio panel. Additionally, the synchronization mechanism can be used to achieve proper time multiplexing of data transfer on the bus. The synchronization of sampling and data transfer leads to improved audio quality in the system, allowing the crew of the bus to easily and effectively communicate.

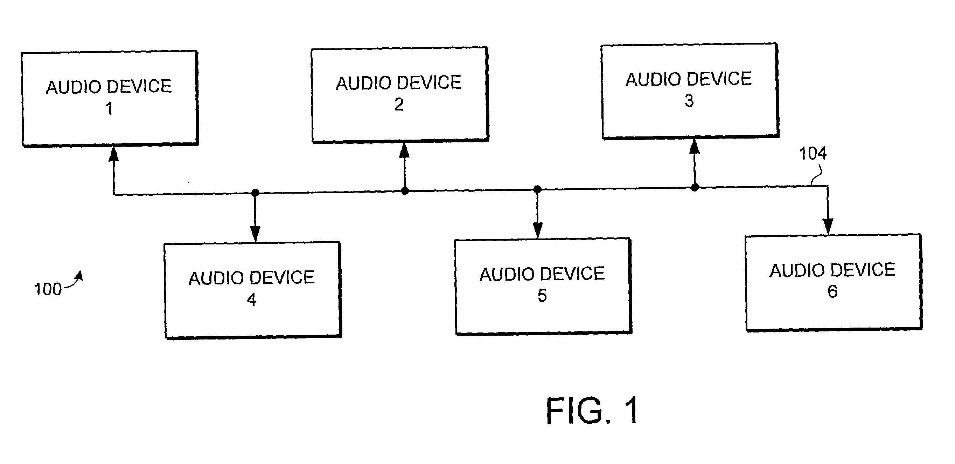

Turning now to FIG. 1, an exemplary distributed audio system 100 is illustrated schematically. The distributed audio system 100 includes audio devices 1-6 coupled together with bus 104. The distributed audio system 100 facilitates communication between people at remote locations, such as between different crew members of an aircraft. Audio communication is received at each audio device, and is transmitted across the bus 104 to the other audio devices where it is outputted. As will be explained in greater detail, the bus 104 is preferably a digital bus that uses multiplexing to allow communication from each audio device to every other audio device in the system 100 on a single bus.

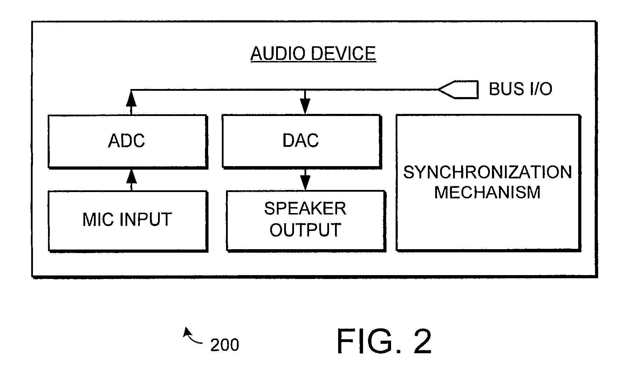

Turning now to FIG. 2, a more detailed schematic view of an exemplary audio device 200 is illustrated. The audio device 200 includes a bus I/O, a microphone input, a speaker output, an analog-to-digital converter (ADC), a digital-to-analog converter (DAC) and a synchronization mechanism. The microphone input receives audio communication from a user and sends it to the ADC, where it is converted to digital and put on the bus I/O. The DAC receives audio signals from bus I/O and passes the converted signals to the speaker where they are outputted back the user. The microphone input can be any suitable type of audio input that converts sound waves into a suitable electrical signals, including headset microphones commonly used in aircraft, telephonic devices, and other audio inputs. The speaker output can be any suitable audio output that converts electrical signals to audible sound, including loudspeakers, headphones, intercom systems, telephonic devices and other such devices.

The ADC and DAC can be any suitable type of converter. For example, they can comprise linear converters that convert 16 bit audio to a 16 bits per sample signal. These samples can then be converted to 8 bits per sample so two samples can be transmitted at a time at the slower rate.

Likewise, the bus I/O can be any suitable type of bus interface. In one example, the bus is a digital time multiplexed bus. In this type of bus, each audio device transmits in its own specified time slot. In such the bus the bus I/O could comprise a CODEC that encodes data to be put on the bus and decodes data from the bus, using any suitable encoding scheme. The bus I/O thus receives audio samples taken by the microphone input and converted by the ADC and encodes those samples into a format suitable for digital bus transmission. The bus I/O then puts those samples on the bus at a time slot specified for the audio device. Likewise, the bus I/O receives signals from the time slots associated with other audio devices. These signals can be decoded, filtered and summed, and the resulting output passed to the DAC. The DAC converts the resulting output and sends it to the speaker for outputting to the user.

The synchronization mechanism synchronizes the sample time of the microphone input with the sampling of microphones on other audio devices. Additionally, the synchronization mechanism can synchronize the output of the speaker with the outputs of other audio devices. Finally, the synchronization mechanism can be used to time the placement of data on the bus I/O by each audio device to achieve proper time multiplexing of data transfer on the bus.

The synchronization mechanism synchronizes the audio devices by comparing the time of arrival of some specified portion of the bus signal to a clock in the audio device. If the relationship between the time of arrival and the clock is off, the synchronization mechanism adjusts the clock rate to correct the timing. Small adjustments in the clock rate are used to move the clock in the proper phase relationship with the bus signal. These comparisons are preferably made at regular intervals, such as at each arrival of a packet on the bus. By continuously comparing the clock to the time of arrival of the specified portion of the bus signal, and then adjusting the clock in response to the comparison, the clock can be put in and kept at the proper phase relationship with the bus signal. With such a synchronization mechanism residing and operating on each audio device, the clocks on each audio device can be synchronized with the bus and thus to each other. This allows the all the audio devices on the distributed audio system to be synchronized such that each audio device samples from the microphone input and outputs to the speaker output at the same time.

The synchronization mechanism can selectively adjust the clock rate in any suitable manner or with any suitable procedure. One method for selectively adjusting the clock rate is to selectively add or subtract clock cycles to the source clock used to generate the timing clock. In this the discussion the term "timing clock" will be used to distinguish the clock that is to be adjusted for synchronization. The timing clock will generally be a clock that directly or indirectly controls the timing of sampling of audio signals from the microphone input and the outputting of audio signals at the speaker output.

In systems that use a variety of clocks, it is common for a high speed clock to serve as the basis for other clocks in the system. For example, the internal audio device can include an 80 MHz source clock that serves as the source clock for other clocks in the system. These other clocks would be generated by dividing down the 80 MHz clock to a lower clock speed. For example, the 80 MHz clock can be divided down by ten to generate an 8 MHz timing clock. The 8 MHz timing clock can be further divided down to provide other clocks, such as dividing by two to provide a 4 MHz bit clock that directly controls sampling. Of course, this is just one example of the type of clock arrangement that the synchronization mechanism applies to.

In such a system, one way to adjust the clock rate of the timing clock is to selectively add or subtract clock cycles to the source clock used to generate the clock. For example, depending of the difference between the timing clock and the arrival of the bus signal, the timing clock can be adjusted by adding (or subtracting) 0, 1, 2, 3, or 4 source clock signals to the master clock. In the example using the 80 MHz source clock and an 8 MHz timing clock, the timing clock can be adjusted by adding ± 1, ± 2, ± 3, or ± 4 source clock signals in between timing clock cycles. This creates a small adjustment in the rate of the 8 MHz timing clock, which in turn adjusts the 4 MHz bit clock. Thus, by selectively choosing the amount of adjustment made to the timing clock, the timing clock and the bit clock can be moved into a proper phase relationship with the bus signal. As an example, the 80 MHz to 8 MHz divider normally counts 10 transitions between switches of the output state. This causes the 80 MHz input clock to result in an 8 MHz output. The frequency of the output can be adjusted by instead counting 9 or 11 transitions between switches between 1 and 4 times during each 128 microsecond bus cycle.

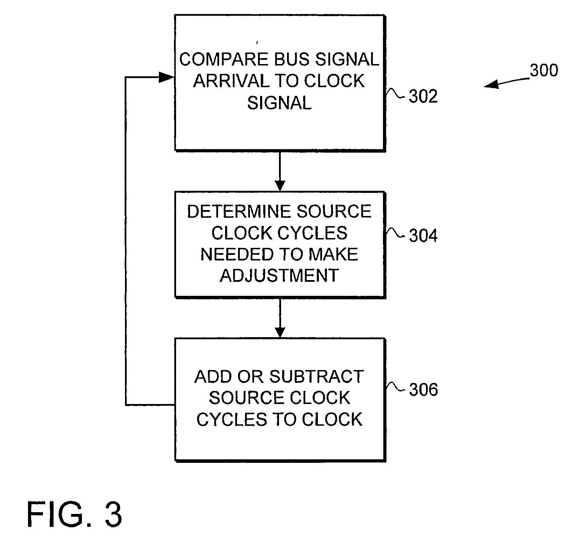

Turning now to FIG. 3, a method 300 for synchronizing audio devices is illustrated. The first step 302 is to compare the bus signal arrival to the clock signal. Typically, this can be done by comparing a known point on the bus signal, such as a selected time slot, with a selected clock edge. The difference amount from a desired clock phase and the current clock phase can be determined my measuring when a selected point on the bus signal arrives and comparing it the phase of the clock, and comparing the difference to the desired time difference. Thus, it can be determined if the timing clock signal has the proper phase relationship with the bus signal, and the amount it is off, if any. It should be noted that the timing clock does not need to be compared directly, and that instead a derivative clock, such as the exemplary 4 MHz bit clock can be compared, indirectly giving information on the timing of the timing clock.

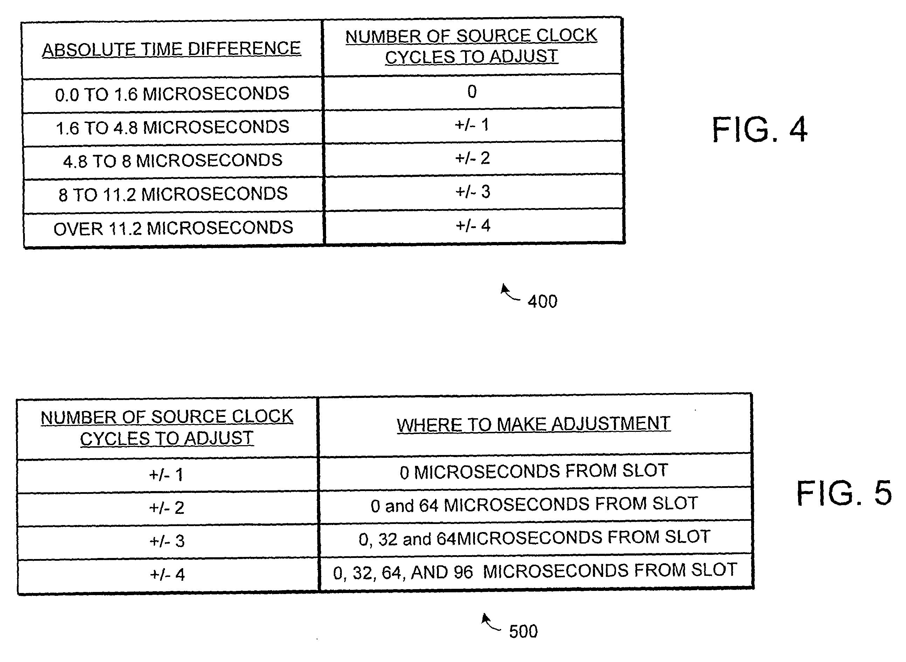

The next step 304 is to determine the number of source clock cycles to needed to make the adjustment. Generally, the greater the phase error, the greater the clock adjustment that is needed. Turning now to FIG. 4, a table 400 illustrating an adjustment scheme where the source clock is an 80 MHz clock and the timing clock is an 8 MHz clock. Table 400 illustrates a set of clock adjustments that can be used in the synchronization method. For example, when the absolute time difference between a clock event and a selected portion of the bus signal is 0.0 to 1.6 microseconds, the clock is not adjusted. When the difference is between 1.6 and 4.8 microseconds, the 8 MHz timing clock is adjusted by 1 80 MHz clock cycle. Thus, one additional 80Mhz clock cycle is added to or subtracting from the 8 MHz timing clock cycle, thus slightly adjust the rate of the 8 MHz clock signal. If the audio device is early compared to the bus signal, clock cycles are added to make it later the next time. If the audio device is late, clock cycles are subtracted to make it earlier the next time. FIG. 4 thus gives one example of how the amount of clock adjustment needed can be determined based upon the absolute time difference determined.

Retuning to method 300, the next step 306 is to add or subtract source clock cycles to the timing clock. The number of cycles added or subtracted would be that determined in step 304. These cycles are added or subtracted by the clock divider.

Preferably, when multiple clock cycle adjustments are made they are spread out over the whole clock cycle. This allows the system to only have to deal with small changes, made relatively often, rather than large changes that could be more disruptive to the system. Turning now to FIG. 5, a table 500 illustrates an example of how multiple clock cycle adjustments can be spread out over the clock cycle. If only one 80 MHz clock cycle is to be added or subtracted from the 8 MHz clock, the change is done at the specified bus signal slot. If two 80 MHz clock cycles are to be added or subtracted, then one is done at the slot, and the other 64 microseconds from the slot. This spreads the resulting change throughout the 8 MHz timing clock cycle.

It should be again noted that the values given in FiGS. 4 and 5 are just an example of the type of determinations that can be made in adjusting the cycle of the clock. For systems with different clock speeds, the time difference and amount of cycles used would generally change.

The present invention thus provides a synchronization mechanism and method for synchronizing remote audio devices that are coupled together with a bus. The synchronization mechanism compares a signal on the bus with a clock signal on the audio device and adjusts the clock in response to the comparison. This allows the synchronization mechanism to accurately synchronize remote audio devices without requiring high precision clocks or other complicated solutions.

The synchronization mechanism and method are particularly applicable to synchronizing remote audio devices in a distributed audio system that digitally sample and broadcast for communication purposes. In this application, the synchronization mechanism improves audio quality by synchronizing the sampling and outputting of each audio device on the bus. This improves audio quality by reducing the distortion that occurs as a result of varying sample times.

## Claims

1. An apparatus comprising:
a plurality of remote audio devices (200), each of the plurality of audio devices (200) coupled to a bus (104) and receiving a bus signal, each of the plurality of audio devices (200) including:
a microphone input, the microphone input adapted to sample sound for distribution on the bus (104);
a speaker adapted to output sound distributed on the bus (104);
a clock, the clock having a clock rate; and
a synchronization means, the synchronization means adapted to receive the bus signal and compare bus signal to the clock, the synchronization means further adapted to adjust the clock rate of the clock to synchronize the sampling of sound with sampling of sound on other of the plurality of audio devices (200).

2. The apparatus of claim 1 wherein the synchronization means is further adapted to synchronize the outputting of sound with outputting of sound on the other of the plurality of audio devices (200).

3. The apparatus of claim 1 wherein the synchronization means is adapted to adjust the clock rate by adding or subtracting clock cycles from a source clock related to the clock.

4. The apparatus of claim 1 wherein the synchronization means is adapted to compare bus signal to the clock by determining a difference amount from a desired clock phase with a current clock phase and wherein the means is adapted to adjust the clock rate by adding or subtracting a number of clock cycles from a source clock related to the clock, wherein the number of clock cycles is related to the difference amount.

5. A method for synchronizing first and second audio devices (200) connected by a bus (104), the method comprising the steps of:
comparing the time of arrival of a bus signal to the second audio device (200) with a clock signal on the second audio device (200); and
adjusting the clock signal on the second audio device (200) in response to the comparison, wherein the step of adjusting the clock signal comprises adjusting the clock signal to synchronize sampling of a first microphone input of the first audio device (200) and a second microphone input of the second audio device (200).

6. The method of claim 5 wherein the step of adjusting the clock signal further comprises adjusting the clock signal to synchronize outputting of a first speaker output of the first audio device (200) and a second speaker output of the second audio device (200).

## Patentansprüche

1. Vorrichtung, umfassend:
mehrere ferngesteuerte Audiogeräte (200), wobei jedes der mehreren Audiogeräte (200) an einen Bus (104) gekoppelt ist und ein Bussignal empfängt, und jedes der mehreren Audiogeräte (200) aufweist:
einen Mikrofoneingang, wobei der Mikrofoneingang so ausgelegt ist, dass er Ton zur Verteilung auf dem Bus (104) abtastet;
einen Lautsprecher, der so ausgelegt ist, dass er Ton ausgibt, der auf dem Bus (104) verteilt wird;
einen Takt, wobei der Takt eine Taktfrequenz aufweist; und
ein Synchronisationsmittel, wobei das Synchronisationsmittel so ausgelegt ist, dass es das Bussignal empfängt und das Bussignal mit dem Takt vergleicht, und das Synchronisationsmittel ferner so ausgelegt ist, dass es die Taktfrequenz des Takts einstellt, um die Abtastung von Ton mit der Abtastung von Ton an einem anderen der mehreren Audiogeräte (200) zu synchronisieren.

2. Vorrichtung nach Anspruch 1, wobei das Synchronisationsmittel ferner so ausgelegt ist, dass es die Ausgabe von Ton mit der Ausgabe von Ton am anderen der mehreren Audiogeräte (200) synchronisiert.

3. Vorrichtung nach Anspruch 1, wobei das Synchronisationsmittel so ausgelegt ist, dass es die Taktfrequenz durch Addieren oder Subtrahieren von Taktzyklen von einem Quelltakt, der mit dem Takt in Beziehung steht, einstellt.

4. Vorrichtung nach Anspruch 1, wobei das Synchronisationsmittel so ausgelegt ist, dass es das Bussignal mit dem Takt durch Bestimmen eines Differenzbetrags von einer gewünschten Taktphase mit einer aktuellen Taktphase vergleicht, und wobei das Mittel so ausgelegt ist, dass es die Taktfrequenz durch Addieren oder Subtrahieren einer Anzahl von Taktzyklen von einem Quelltakt, der mit dem Takt in Beziehung steht, einstellt, wobei die Anzahl von Taktzyklen mit dem Differenzbetrag in Beziehung steht.

5. Verfahren zum Synchronisieren erster und zweiter Audiogeräte (200), die durch einen Bus (104) verbunden sind, wobei das Verfahren die folgenden Schritte aufweist:
vergleichen der Ankunftszeit eines Bussignals am zweiten Audiogerät (200) mit einem Taktsignal am zweiten Audiogerät (200); und
Einstellen des Taktsignals am zweiten Audiogerät (200) als Reaktion auf den Vergleich, wobei der Schritt des Einstellens des Taktsignals das Einstellen des Taktsignals, um eine Abtastung eines ersten Mikrofoneingangs des ersten Audiogeräts (200) und eines zweiten Mikrofoneingangs des zweiten Audiogeräts (200) zu synchronisieren, aufweist.

6. Verfahren nach Anspruch 5, wobei der Schritt des Einstellens des Taktsignals ferner das Einstellen des Taktsignals, um eine Ausgabe eines ersten Lautsprecherausgangs des ersten Audiogeräts (200) und eines zweiten Lautsprecherausgangs des zweiten Audiogeräts (200) zu synchronisieren, aufweist.

## Revendications

1. Appareil comprenant :
une pluralité de dispositifs d'écoute à distance (200), chaque dispositif de la pluralité de dispositifs d'écoute (200) étant couplé à un bus (104) et recevant un signal de bus, alors que chaque dispositif de la pluralité de dispositifs d'écoute (200) comporte :
une entrée de microphone, l'entrée de microphone étant adaptée de façon à échantillonner le son en vue d'une distribution sur le bus (104) ;
un haut-parleur qui est adapté de façon à délivrer le son distribué sur le bus (104) ;
une horloge, l'horloge ayant une fréquence de base ; et
un moyen de synchronisation, le moyen de synchronisation étant adapté pour recevoir le signal de bus et pour comparer le signal de bus à l'horloge, le moyen de synchronisation étant adapté en outre de façon à ajuster la fréquence de base de l'horloge afin de synchroniser l'échantillonnage de son avec l'échantillonnage de son sur un autre dispositif de la pluralité de dispositifs d'écoute (200).

2. Appareil, selon la revendication 1, le moyen de synchronisation étant adapté en outre de façon à synchroniser la fourniture de son avec la fourniture de son sur l'autre dispositif de la pluralité de dispositifs d'écoute (200).

3. Appareil, selon la revendication 1, le moyen de synchronisation étant adapté de façon à ajuster la fréquence de base grâce à l'addition ou à la soustraction de cycles d'horloge provenant d'une horloge source liée à l'horloge.

4. Appareil, selon la revendication 1, le moyen de synchronisation étant adapté de façon à comparer le signal de bus à l'horloge en déterminant un montant de différence entre une phase d'horloge désirée et une phase d'horloge en cours, et le moyen étant adapté de façon à ajuster la fréquence de base grâce à l'addition ou à la soustraction de cycles d'horloge provenant d'une horloge source liée à l'horloge, alors que le nombre de cycles d'horloge est lié au montant de différence.

5. Procédé pour synchroniser un premier et un deuxième dispositifs d'écoute (200) connectés par un bus (104), le procédé comprenant les étapes consistant à :
comparer le moment d'arrivée d'un signal de bus au niveau du deuxième dispositif d'écoute (200) avec un signal d'horloge sur le deuxième dispositif d'écoute (200) ; et
ajuster le signal d'horloge sur le deuxième dispositif d'écoute (200) en réaction à l'opération de comparaison, alors que l'étape consistant à ajuster le signal d'horloge comprend l'ajustement du signal d'horloge afin de synchroniser l'échantillonnage d'une première entrée de microphone du premier dispositif d'écoute (200) et d'une deuxième entrée de microphone du deuxième dispositif d'écoute (200).

6. Procédé, selon la revendication 5, l'étape consistant à ajuster le signal d'horloge comprenant en outre l'ajustement du signal d'horloge afin de synchroniser la fourniture d'une première sortie de haut-parleur du premier dispositif d'écoute (200) et d'une deuxième sortie de haut-parleur du deuxième dispositif d'écoute (200).
